# EUROPÄISCHE PATENTSCHRIFT

(11) **EP 1 186 021 B1**
(45) Veröffentlichungstag und Bekanntmachung des Hinweises auf die Patenterteilung: **06.12.2006**
(21) Anmeldenummer: 00920678.0
(22) Anmeldetag: 07.04.2000
(51) Int. Cl.: H01L 21/58

(54) **MIKROELEKTRONISCHE BAUGRUPPE**
MICROELECTRONIC SUBASSEMBLY
MODULE MICROELECTRONIQUE

(30) Priorität: 30.04.1999 DE 19919716
(43) Veröffentlichungstag der Anmeldung: 13.03.2002
(73) Patentinhaber: Conti Temic microelectronic GmbH, 90411 Nürnberg (DE)
(72) Erfinder: SAUTER, Klaus, D-89143 Blaubeuren (DE); MAHRLE, Jörg, D-73035 Göppingen (DE)
(86) Internationale Anmeldenummer: PCT/EP2000/003140
(87) Internationale Veröffentlichungsnummer: WO 2000/067310

(56) Entgegenhaltungen:
- WO-A-97/22993
- US-A- 4 545 840
- PATENT ABSTRACTS OF JAPAN vol. 010, no. 121 (E-401), 7. Mai 1986 (1986-05-07) & JP 60 253280 A (TATEISHI DENKI KK), 13. Dezember 1985 (1985-12-13)
- "CHIP-HEATSINK ATTACH USING CONTOURED ADHESIVE WITH GLASS STAND-OFFS" IBM TECHNICAL DISCLOSURE BULLETIN,US,IBM CORP. NEW YORK, Bd. 34, Nr. 3, 1. August 1991 (1991-08-01), Seiten 161-162, XP000210487 ISSN: 0018-8689

## Beschreibung

Die Erfindung betrifft eine mikroelektronische Baugruppe gemäß dem Oberbegriffs des Anspruchs 1, welche aus der WO-A-9722993 bekannt ist.

Beispielsweise aus der DE-A1 2756500 ist die Verwendung annähernd kugelförmiger Teilchen als Abstandshalter für eine Klebeverbindung zwischen zwei mikroelektronischen Baugruppen zu entnehmen. Die kugelförmigen Teilchen weisen dabei einen Durchmesser gleich dem gewünschten Abstand auf und bilden dabei in einer Vielzahl in der Klebstoffschicht verteilt die Abständshalterung.

In dem DE-GM 91 16 206 werden kugelförmige Körper als Abstandselemente zwischen Isolierglasscheiben genutzt, die bei erhöhtem Druck plastisch unter Bildung von Abflachungen oberflächlich verformbar sind, wodurch die Fertigungstoleranzen der kugelförmigen Abstandselemente durch Pressen auf einen Sollabstand reduziert werden können.

Darüber hinaus werden in der Praxis Baugruppen mit kräftempfindlichen Sensorelementen, bspw. Beschleunigungssensoren für Kraftfahrzeuge, mittels Verklebens mit derartigen kugelförmigen Abstandselementen auf einem Trägerelement, bspw. einer Leiterplatte, befestigt. Als kugelförmige Abstandselemente werden dabei bisher Glaskugeln eingesetzt, da diese elektrostatisch unempfindlich sind, sich daher relativ einfach in den Klebstoff einmischen und sich in diesem verteilen lassen und sehr preiswert sind. Da die Klebstoffschicht bei einer definierten Aushärtetemperatur vernetzt, welche oberhalb des Einsatztemperaturbereichs liegt, treten am Sensorelement meßbare Verspannungen zwischen dem Bauelement und der Klebstoffschicht auf, die eine zusätzliche Verschiebung des elektrischen Nullpunkts des Bauelements bewirkt. Dies muß durch einen Offset bei der zu sensierenden Größe kompensiert werden. Trotz dieser Offset-Kompensation traten jedoch weiter Meßungenauigkeiten auf, insbesondere wenn das Bauelement nur mittels eines Klebstofftropfens befestigt wurde.

Beispielsweise aus der US 4,295,117 ist die Problematik der mechanischen Verspannung bei Temperaturänderungen in der Umgebung eines Sensors ebenfalls bekannt. Es wird eine Trägerplatte mit annähernd gleichem thermischen Ausdehnungskoeffizienten wie der Sensorchip gewählt, wobei jedoch zwischen der Trägerplatte und dem Chip ein Sockel und Trägerwürfel angeordnet sind, die untereinander beziehungsweise mit dem Chip durch einen elastischen Klebstoff verbunden sind, so dass der Chip von den Verspannungen der Trägerplatte isoliert wird. Innerhalb dieser Klebung kann es jedoch gerade zu unerwünschten Verspannungen, wenn der Klebstoff die Abweichung der Längenänderungen kompensiert.

Aufgabe der Erfindung ist, eine Baugruppe der eingangs genannten Art weiterzuentwickien, die geringere Toleranzen aufweist und eine einfache Montage ermöglicht. Diese Aufgabe wird durch die kennzeichenden Merkmale des Anspruchs 1 gelöst. Vorteilhafte Weiterbildungen sind den Unteransprüchen zu entnehmen.

Als Ursache dieser Meßungenauigkeiten wurde eine temperaturabhängige Verspannung am Bauelement ermittelt, die auf den stark unterschiedlichen thermischen Ausdehnungskoeffizienten des Klebstoffs einerseits und der kugelförmigen Abstandselemente andererseits beruht. So kam es zu einer Scherwirkung der Glaskugeln gegen die Montagefläche des Bauelements, wenn sich die Klebstoffschicht bei niedrigen Temperaturen zusammenzieht. Wird dies für eine Normtemperatur durch Offset-Kompensation ausgeglichen, treten bei höheren Temperaturen und damit geringerer Scherwirkung wiederum Abweichungen auf.

Durch Verwendung von Abstandselementen, deren thermischer Ausdehnungskoeffizient dem Ausdehnungskoeffizienten des Klebstoffs annähernd entspricht, also zumindest deutlich näher kommt als der von den bisher verwendeten Glas-kugeln, konnte eine deutliche Verbesserung der Fertigungsausbeute und eine kleinere Toleranzbreite erreicht werden. Bevorzugt lassen sich dazu Kunststoffkugel einsetzen, deren Ausdehnungskoeffizient relativ gut beeinflußt werden kann. Kunststoffkugeln weisen zwar ein geringeres Gewicht und eine Neigung zur elektrostatischen Aufladung auf, was jedoch durch entsprechende Schritte beim Vermischen von Klebstoff und Abstandselementen bereits kompensiert werden kann. Besonderer Vorteil des Kunststoffs ist neben der Annäherung des thermischen Ausdehnungskoeeffizenten dessen Elastizität, wodurch die Scherwirkung weiter reduziert werden konnte.

Indem der thermische Ausdehnungskoeffizient des Abstandselements nicht mehr als um den Faktor 10 kleiner ist als derjenige des Klebstoffs, konnte eine ausreichende Annäherung und eine deutliche Verbesserung der Temperatur- und Fertigungstoleranzen festgestellt werden.

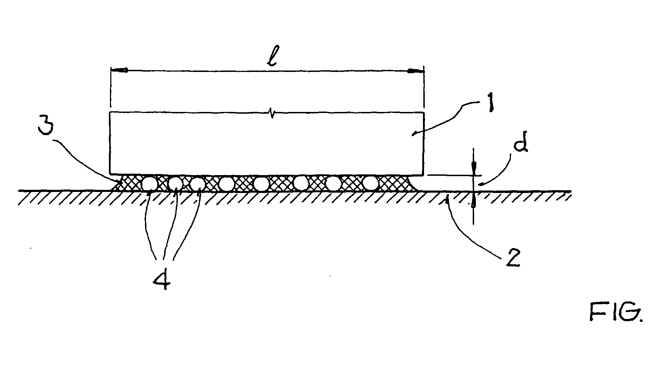

Die Erfindung soll nachfolgend anhand eines Ausführungsbeispiels und der Figur näher erläutert werden. Kurze Beschreibung der Figur:
- Figur: Baugruppe mit mikroelektronischem Bauelement verbunden über eine Klebstoffschicht mit einem Trägerelement

Die einzige Figur zeigt skizzenhaft eine Baugruppe mit einem mikroelektronischen Bauelement, bspw. einem piezoelektrischen oder kapazitiven Beschleunigungssensorelement, welches mit einer Montagefläche, hier der Bauelementeunterseite, über eine Klebstoffschicht 3 mit einem Trägerelement 2, bspw. einer Leiterplatte, verbunden ist. In der Klebstoffschicht 3 sind eine Vielzahl annähernd kugelförmiger Abstandselemente 4 verteilt, die entsprechend ihrem Durchmesser den vorgegebenen Abstand d zwischen Bauelement und Trägerelement bewirken, wobei in der Figur die Dicke der Klebstoffschicht 3 bzw. dieser Abstand d sowie der Durchmesser der annähernd kugelförmigen Abstandselemente 4 gegenüber den anderen Zeichnungselementen zur besseren Verdeutlichung vergrößert wurde.

Der Durchmesser der Abstandselemente und damit der Abstand beträgt beispielsweise zwischen 50 und 200 µm.

Bei den herkömmlichen Glaskugeln konnte es auch bei diesen relativ geringen Durchmessern bereits zu einer Verspannung der Montagefläche des Bauelements 1 kommen, da üblicherweise der Klebstoff 3, bspw. Silikonkleber einen thermischen Ausdehnungskoeffizient von ca. 8*10⁻⁴ 1/K aufweist, Glas hingegen einen um etwa den Faktor 100 geringeren, also bei etwa 8*10⁻⁶ l/K.

Durch ein Abstandselement mit an den Klebstoff angenähertem Ausdehnungskoeffizient, der insbesondere nicht mehr als um den Faktor 10 kleiner ist als derjenige des Klebstoffs, können diese Verspannungen deutlich reduziert werden, indem die Abstandselemente bei auftretenden Temperaturschwankungen nicht mehr starr bleiben und so eine Scherwirkung hervorrufen sondern selbst, wenn auch in geringerem Maße, die Spannung aufnehmen und sich selbst verformen.

So ist ein Kunststoffgemisch mit einem thermischen Ausdehnungskoeffizient von 4-6*10⁻⁵ 1/K ohne weiteres machbar und kann für diese Abstandselemente verwendet werden. Die Temperaturabhängigkeit des Bauelements nimmt bereits wesentlich ab. Eine noch weitere Annäherung bedeutet einen höheren Aufwand, ist dennoch grundsätzlich denkbar. Der trotz allem mit dem Faktor 10 relativ große Unterschied bei der Wärmeelastizität ist deshalb schon ein deutlicher Fortschritt, weil die Empfindlichkeit des Sensorelements extrem hoch ist. So werden im konkreten Anwendungsfall Beschleunigungen mit einer Genauigkeit von 0,1g erfaßt, die einer Abstandsänderung zwischen der internen seismischen Masse des Sensorelements und dem festem Boden von 0,02 µm entspricht. Der Meßbereich geht dabei bis 3g. Der Temperaturbereich muß bei Kraftfahrzeugsensoranwendungen von - 40°C bis + 120°C ausgelegt werden.

Während dabei die Glaskugeln bei einem Abstand von 200µm eine thermische Ausdehnung von max. 0,1 µm aufwiesen, veränderte sich der Klebstoff um ca. 25 µm. Der Kunststoff erreicht demgegenüber zumindest eine Nachgiebigkeit von 2µm, was ausgehend von einer Meßgenauigkeit von 0,02 µm und einem maximalen Aussteuerungsbereich der seismischen Masse im Sensorelement von 0,7 µm bereits eine deutliche Verbesserung des Temperaturverhaltens bedeutet.

Insbesondere ist es so möglich, das Bauelement mittels eines einzigen Klebstofftropfens auf dem Trägerelement zu befestigen, auf den das Bauelement mittig aufgepreßt wird. Zuvor wurde das Bauelement jeweils an den Ecken geklebt, um ein vertretbares Temperaturverhalten zu bekommen.

## Patentansprüche

1. Mikroelektronische Baugruppe mit einem mikroelektronischen Bauelement (1), insbesondere einem Sensorbauelement, mit einer Montagefläche, wobei
a) das Bauelement an einem Trägerelement (2) durch eine Klebstoffschicht (3) befestigt ist und
b) die Klebstoffschicht (3) eine Vielzahl annähernd kugelförmiger Abstandselemente (4) enthält, deren Durchmesser (d) einem vorgegebenen Abstand von der Montagefläche zum Trägerelement (2) entspricht,
c) der thermische Ausdehnungskoeffizient der Abstandselemente (4) dem Ausdehnungskoeffizienten des Klebstoffs (3) annähernd entspricht, und
**dadurch gekennzeichnet dass** die Abstandselemente (4) aus einem Verspannungen zumindest in geringem Maße elastisch nachgiebigem Kunststoff sind.

2. Mikroelektronische Baugruppe nach Anspruch 1, wobei der thermische Ausdehnungskoeffizient des Abstandselements (4) nicht mehr als um den Faktor 10 kleiner ist als derjenige des Klebstoffs (3).

3. Verfahren zur Herstellung der mikroelektronischen Baugruppe nach Anspruch 1, indem die Klebstoffschicht (3) als ein Tropfen auf dem Trägerelement (4) aufgebracht, nachfolgend das Bauelement (1) dazu mittig aufgepreßt und die Klebstoffschicht (3) ausgehärtet wird.

## Claims

1. A microelectronic assembly with a microelectronic component (1), in particular a sensor component, with a mounting surface, whereby
a) the component is attached to a carrier element (2) by an adhesive layer (3), and
b) the adhesive layer (3) contains a plurality of approximately ball-shaped spacer elements (4), the diameter (d) of which corresponds to a specified distance from the mounting surface to the carrier element (2)
c) the spacer elements (4) are made of a plastic which is elastically pliable when submitted to tensions, at least to a low degree, and **characterised in that**

2. A microelectronic assembly according to claim 1, whereby the thermal expansion coefficient of the spacer element (4) is not smaller than the factor 10 than that of the adhesive (3).

3. A procedure for manufacturing the microelectronic assembly according to claim 1, in which the adhesive layer (3) is applied as a drop to the carrier element (4), subsequently the component (1) is pressed on in the centre and the adhesive layer (3) is hardened.

## Revendications

1. Assemblage microélectronique avec un composant microélectronique (1), en particulier un élément capteur, avec une surface de montage,
a) le composant étant fixé sur un élément support (2) par une couche adhésive (3) et
b) la couche adhésive (3) contenant un grand nombre d'éléments d'écartement (4) approximativement sphériques, dont le diamètre (d) correspond à un écartement fixé de la surface de montage à l'élément support (2),
c) le coefficient de dilatation thermique des éléments d'écartement (4) correspondant approximativement au coefficient de dilatation de la colle (3) et
**caractérisé en ce que** les éléments d'écartement (4) sont en une matière plastique élastiquement souple relativement aux contractions, au moins dans une faible mesure.

2. Assemblage microélectronique selon la revendication 1, le coefficient de dilatation thermique de l'élément d'écartement (4) n'étant pas plus de dix fois plus faible que celui de la colle (3).

3. Procédé pour la fabrication d'un assemblage microélectronique selon la revendication 1, par le fait que la couche adhésive (3) est appliquée sur l'élément support (4) comme une goutte, à la suite de quoi le composant (1) est alors pressé au milieu et la couche adhésive (3) est durcie.
